Europäisches Patentamt

European Patent Office

Office européen des brevets

(19)

(11) Veröffentlichungsnummer: **0 153 650
B1**

(12) **EUROPÄISCHE PATENTSCHRIFT**

(45) Veröffentlichungstag der Patentschrift:
**08.11.89**

(21) Anmeldenummer: **85101472.0**

(22) Anmeldetag: **12.02.85**

(51) Int. Cl.⁴: **H 01 L 25/16, H 01 L 23/28**

(54) Dünnschichthybridschaltung.

(30) Priorität: **02.03.84 DE 3407784**

(43) Veröffentlichungstag der Anmeldung:
**04.09.85 Patentblatt 85/36**

(45) Bekanntmachung des Hinweises auf die Patenterteilung:
**08.11.89 Patentblatt 89/45**

(84) Benannte Vertragsstaaten:
**BE CH FR GB IT LI NL SE**

(56) Entgegenhaltungen:
**FR-A- 2 330 147
GB-A- 2 046 024
US-A- 4 275 407**

(73) Patentinhaber: **Asea Brown Boveri Aktiengesellschaft,
Kallstadter Strasse 1, D-6800 Mannheim-Käfertal (DE)**

(72) Erfinder: **Krokoszinski, Hans-Joachim, Dr. Dipl.-Phys.,
Hermann-Löns-Strasse 10, D-6907 Nussloch (DE)**
Erfinder: **Oetzmann, Henning, Dr. Dipl.-Phys.,
Gartenstrasse 29, D-6901 Mauer (DE)**
Erfinder: **Schmidt, Conrad, Dr. Dipl.-Phys.,
Wielandstrasse 2, D-6901 Gaiberg (DE)**
Erfinder: **Gilbers, Dieter, Dipl.-Ing., Maldegemstrasse 8,
D-6840 Lampertheim (DE)**

(74) Vertreter: **Rupprecht, Klaus, Dipl.-Ing. et al, c/o Asea
Brown Boveri Aktiengesellschaft Zentralbereich
Patente Postfach 100351, D-6800 Mannheim 1 (DE)**

## Beschreibung

Die Erfindung bezieht sich auf ein Verfahren zur Herstellung einer Dünnschichthybridschaltung mit Kontaktflächen für externe Anschlüsse und/oder Bauelemente.

Eine solche Dünnschichthybridschaltung ist aus H.-J. Hanke, H. Fabian, «Technologie elektronischer Baugruppen», 3. Auflage 1982, VEB Verlag Technik, Berlin, Seite 92 bekannt. Dort sind beispielsweise auf einem Substrat Leiterbahnen, Widerstände und Kondensatoren in Dünnschichttechnik aufgedampft bzw. aufgesputtert, während zum Anschluß aktiver Bauelemente, z.B. Transistoren, wie auch zum Anschluß externer Leitungen Kontaktflächen vorgesehen sind.

Für derartige Dünnschichthybridschaltungen ist eine Passivierschicht aus mehreren Gründen wünschenswert. Die aufgedampften bzw. aufgesputterten Strukturen sind nicht hinreichend kratzfest und werden daher leicht während eines Bestückungs- und «Packaging»-Prozesses (Einbau in ein Gehäuse) beschädigt. Ferner korrodieren die Kupfer- und auch Aluminium-Leiterbahnen der Dünnschichtschaltung bei längerer Lagerung an feuchter Luft.

Desweiteren oxidieren freiliegende Kontaktflächen aus Nickel, die später vernickelt und/oder vergoldet werden sollen, beim Temperprozeß an Luft, so daß die chemische Nachverstärkung behindert ist. Ferner werden bei der chemischen Nachverstärkung von Kontaktflächen (Bond- und Lötpads) die Isolationsschichten (z.B. $Al_2O_3$) von Leiterbahnkreuzungen oder Dünnschichtkondensatoren von den (meistens) nicht-neutralen Bädern angegriffen.

Zur Erhöhung der Kratzfestigkeit und zum Schutz gegen die nicht-neutralen Bäder der chemischen Nachverstärkung von Kontaktflächen ist eine dicke organische Schicht (z.B. Photolack) eine geeignete Passivierung. Da diese jedoch den Temperprozeß (typische Temperaturen 300 bis 350°C) nicht unbeschadet übersteht und auch nicht hinreichend dicht gegen Wasserdampfdiffusion ist, empfiehlt sich zur Vermeidung einer Korrosion der Leiterbahnen und einer Oxidation der Kontaktflächen eine anorganische Schicht (z.B. $Al_2O_3$ oder $Si_3N_4$). Diese wiederum ist nicht genügend kratzfest und nicht resistent gegen chemische Bäder.

Der Erfindung liegt die Aufgabe zugrunde, eine Passivierschicht für eine Dünnschichthybridschaltung der eingangs genannten Art herzustellen, die gleichzeitig genügend kratzfest, beständig gegen chemische Bäder, dicht gegen Wasserdampfdiffusion und temperaturbeständig bis ca. 350°C ist.

Diese Aufgabe wird durch die im Anspruch 1 angegebenen Merkmale gelöst.

Die mit der Erfindung erzielbaren Vorteile bestehen insbesondere darin, daß durch die Passivierschichtfolge (anorganische Schutzschicht und gehärtete Photolackschicht) ein Schutz der Dünnschichthybridschaltung vor Oxidation, Korrosion, Wasserdampfdiffusion, mechanischer Beschädigung und chemischen Bädern gewährleistet ist.

Vorteilhafte Ausgestaltungen der Erfindung sowie ein Verfahren zur Herstellung der Dünnschichthybridschaltung sind in den Unteransprüchen gekennzeichnet.

Die Erfindung wird nachstehend anhand der in den Zeichnungen dargestellten Ausführungsform erläutert.

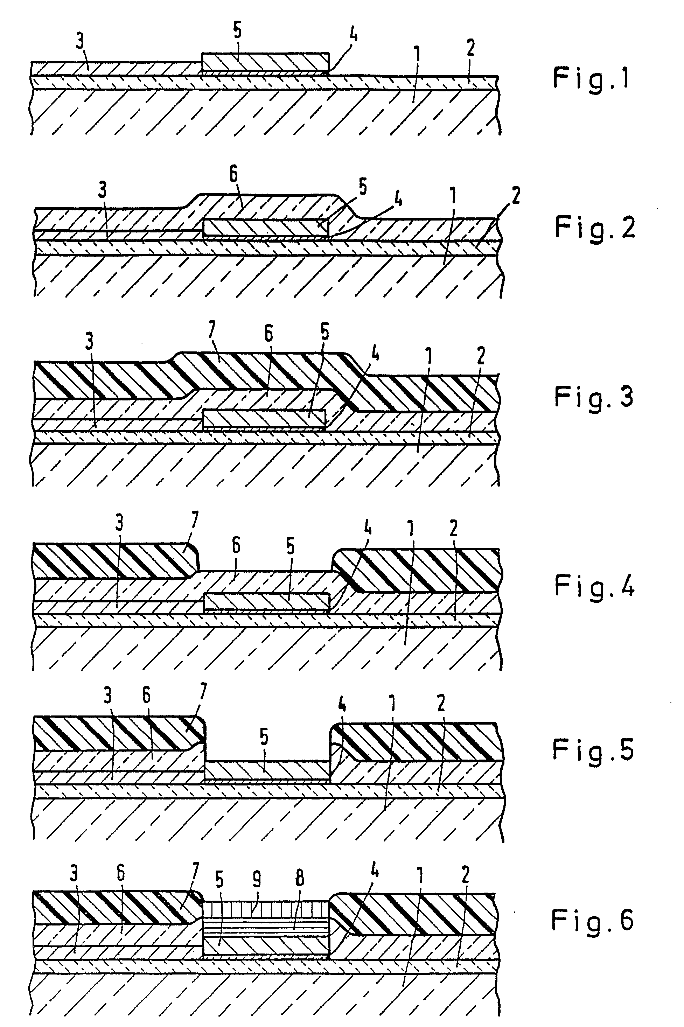

In den Figuren 1 bis 6 sind dabei die einzelnen Verfahrensschritte zur Aufbringung der Passivierschichtfolge für Dünnfilmschaltungen dargestellt.

Als Ausgangsschaltung dient die in Fig. 1 dargestellte vollständig aufgedampfte bzw. aufgesputterte Dünnschichtschaltung. Auf einem Substrat 1 (z.B. Glas) sind dabei eine Grundoxidschicht 2 und darauf beispielsweise eine Leiterbahnschicht 3 aufgebracht. Die Leiterbahnschicht 3 ist mit einer Kontaktfläche (Bond- oder Lötpads), bestehend aus einer auf der Grundoxidschicht 2 aufgebrachten NiCr-Schicht 4 und einer darüberliegenden Ni-Schicht 5 verbunden.

In einem Vakuumprozeß wird die Dünnschichtschaltung homogen mit einer anorganischen Schutzschicht 6, z.B. $Al_2O_3$, $Si_3N_4$ oder Glas bedampft bzw. besputtert, was zu der in Fig. 2 dargestellten Schaltung führt. Die anorganische Schutzschicht 6 schützt die metallischen Schichten, wie Leiterbahnschicht 3 oder Ni-Schicht 5 beim sich anschließenden Temperprozeß gegen Oxidation. Die Temperung der Schaltung wird an Luft bei einer Alterungstemperatur von 300 bis 350°C vorgenommen und dient zur Stabilisierung der Widerstände der Dünnschichtschaltung, d.h. zur Erzielung einer hohen Langzeitkonstanze und einer geringen Temperaturdrift.

Die so abgedeckte und getemperte Schaltung wird in einem nächsten Verfahrensschritt homogen mit einer Photolackschicht 7 beschichtet, was zu der in der Fig. 3 dargestellten Schaltung führt. Anschließend werden die Kontaktflächen (Schichten 4, 5) der Schaltung durch Belichtung durch eine Maske und darauffolgende Entwicklung photolithographisch freigelegt, wie in Fig. 4 gezeigt ist.

Als nächster Verfahrensschritt folgt die Härtung der Photolackschicht 7 bei einer Temperatur, die höher als die bei der Verlötung der Kontaktflächen auftretende Löttemperatur ist.

Anschließend wird die anorganische Schutzschicht 6 ($Al_2O_3$, $Si_3N_4$ oder Glas) auf den Kontaktflächen (NiCr-Schicht 4, Ni-Schicht 5) weggeätzt, was zu der in Fig. 5 dargestellten Schaltung führt. Danach liegen die Kontaktflächen mit einer nicht oxidierten Oberfläche zur chemischen Vernickelung und/oder Vergoldung vor. Beispielsweise kann die Ni-Schicht 5, wie in Fig. 6 dargestellt, mit einer weiteren Ni-Schicht 8 und einer darüberliegenden Au-Schicht 9 versehen werden. Diese «chemische Nachverstärkung» kann auch in nicht-neutralen Bädern erfolgen.

Die so hergestellte Passivierschichtfolge (anorganische Schutzschicht 6 und gehärtete Photolackschicht 7) besitzt folgende Vorteile:

Die anorganische Schutzschicht 6 ist temperaturbeständig und dicht gegen Wasserdampf. Sie übernimmt den Schutz der Schaltung gegen Oxidation beim Tempern und gegen Korrosion durch Luftfeuchtigkeit (Langzeitstabilität). Die gehärtete Photolackschicht 7 ist hinreichend wisch- und kratzfest, d.h. beständiger gegen mechanische Beschädigung. Sie ist photolithographisch strukturierbar und resistent gegen nicht-neutrale Bäder. Dadurch ermöglicht sie an den Kontaktflächen eine selektive Ätzung der anorganischen Schutzschicht 6 und schützt die restliche Schaltung während der chemischen Nachverstärkung der Kontaktflächen. Darüberhinaus wirkt sie beim Bestückungsprozeß als Lötstopschicht.

## Patentansprüche

1. Verfahren zur Herstellung einer Dünnschichthybridschaltung mit Kontaktflächen für externe Anschlüsse und/oder Bauelemente mit folgenden Merkmalen:

a) auf ein mit einem Grundoxid (2) beschichtetes Substrat (1) wird eine Dünnschichtschaltung einschließlich Leiterbahnen (3) und Kontaktflächen (4, 5) vollständig durch Masken aufgedampft bzw. aufgesputtert,

b) die Dünnschichtschaltung wird zur Passivierung im selben Vakuumprozeß homogen mit einer anorganischen Schutzschicht (6) bedampft bzw. besputtert,

c) die Schaltung wird an Luft getempert,

d) es wird eine Photolackschicht (7) aufgebracht und an den Kontaktflächen (4, 5) photolithographisch freigelegt,

e) die Photolackschicht (7) wird gehärtet,

f) die anorganische Schutzschicht (6) wird am Ort der Kontaktflächen (4, 5) weggeätzt.

2. Verfahren nach Anspruch 1, dadurch gekennzeichnet, daß eine $Al_2O_3$-Schicht als anorganische Schutzschicht (6) dient.

3. Verfahren nach Anspruch 1, dadurch gekennzeichnet, daß eine $Si_3N_4$-Schicht als anorganische Schutzschicht (6) dient.

4. Verfahren nach Anspruch 1, dadurch gekennzeichnet, daß eine Glasschicht als anorganische Schutzschicht (6) dient.

5. Verfahren nach einem der vorstehenden Ansprüche, dadurch gekennzeichnet, daß die Kontaktflächen (4, 5) chemisch vernickelt und/oder vergoldet werden.

## Claims

1. Process for manufacturing a thin-film hybrid circuit having contact areas for external connections and/or components, characterized in that:

a) a thin-film circuit including conductor tracks (3) and contact areas (4, 5) is completely vapour-deposited or sputtered through masks onto a substrate (1) coated with a base oxide (2),

b) an inorganic protective layer (6) is uniformly vapour-deposited or sputtered onto the thin-film circuit for the purpose of passivation in the same vacuum process,

c) the circuit is annealed in air,

d) a photoresist layer (7) is deposited and photolithographically laid bare at the contact areas (4, 5),

e) the photoresist layer (7) is cured,

f) the inorganic protective layer (6) is etched away at the site of the contact areas (4, 5).

2. Process according to Claim 1, characterized in that an $Al_2O_3$ layer acts as inorganic protective layer (6).

3. Process according to Claim 1, characterized in that an $Si_3N_4$ layer acts as inorganic protective layer (6).

4. Process according to Claim 1, characterized in that a glass layer acts as inorganic protective layer (6).

5. Process according to one of the preceding claims, characterized in that the contact areas (4, 5) are electrolessly nickel-plated and/or gold-plated.

## Revendications

1. Procédé pour fabriquer un circuit hybride à couche mince avec des surfaces de contact pour des raccordements externes et/ou des composants, avec des caractéristiques suivantes:

a) sur un substrat (1) revêtu d'un oxyde de base (2), on applique par vaporisation ou par pulvérisation, entièrement à travers des masques, un circuit à couche mince, y compris des pistes conductrices (3) et des surfaces de contact (4, 5),

b) pour la passivation, on vaporise ou pulvérise, pendant le même processus sous vide, une couche de protection (6) inorganique de manière homogène sur le circuit à couche mince,

c) le circuit est recuit à l'air,

d) une couche de laque photosensible (7) est appliquée et est dégagée par voie photolithographique aux surfaces de contact (4, 5),

e) la couche de laque photosensible (7) est durcie,

f) la couche de protection (6) inorganique est enlevée par attaque à l'acide à l'endroit des surfaces de contact (4, 5).

2. Procédé selon la revendication 1, caractérisé par le fait qu'une couche de $Al_2O_3$ sert de couche de protection (6) inorganique.

3. Procédé selon la revendication 1, caractérisé par le fait qu'une couche de $Si_3N_4$ sert de couche de protection (6) inorganique.

4. Procédé selon la revendication 1, caractérisé par le fait qu'une couche de verre sert de couche de protection (6) inorganique.

5. Procédé selon l'une quelconque des revendications précédentes, caractérisé par le fait que les surfaces de contact (4, 5) sont nickelées et/ou dorées par voie chimique.

Fig.1

Fig.2

Fig.3

Fig.4

Fig.5

Fig.6